# EUROPEAN PATENT SPECIFICATION

(11) **EP 0 789 397 B1**
(45) Date of publication and mention of the grant of the patent: **06.05.2004**
(21) Application number: 97300625.7
(22) Date of filing: 30.01.1997
(51) Int. Cl.: H01L 23/373, H01L 23/15

(54) **Circuit board and semiconductor device using the circuit board**
Schaltungsplatine und Halbleiterbauteil mit dieser
Plaquette de circuit et dispositif semi-conductrice comportant ladite plaquette

(30) Priority: 07.02.1996 JP 2089796
(43) Date of publication of application: 13.08.1997
(73) Proprietor: Hitachi, Ltd., Chiyoda-ku, Tokyo 101 (JP)
(72) Inventor: Tanaka, Akira, Mito-shi, Ibaraki 310 (JP); Kushima, Tadao, Naka-gun, Ibaraki 319-11 (JP); Shimizu, Hideo, Mito-shi, Ibaraki 310 (JP); Okada, Sensuke, Hitachinaka-shi, Ibaraki 312 (JP); Koike, Yoshihiko, Hitachinaka-shi, Ibaraki 312 (JP); Yamada, Kazuji, Hitachi-shi, Ibaraki 316 (JP); Saito, Ryuichi, Hitachi-shi, Ibaraki 319-12 (JP)
(74) Representative: Hackney, Nigel John

(56) References cited:
- EP-A- 0 712 153
- EP-A- 0 766 307
- DE-A- 4 031 814
- US-A- 4 505 418

## Description

The present invention relates to a technique of mounting a power semiconductor device and, more specifically, to a semiconductor device of a module structure including an insulating substrate with a conductive foil bonded thereto.

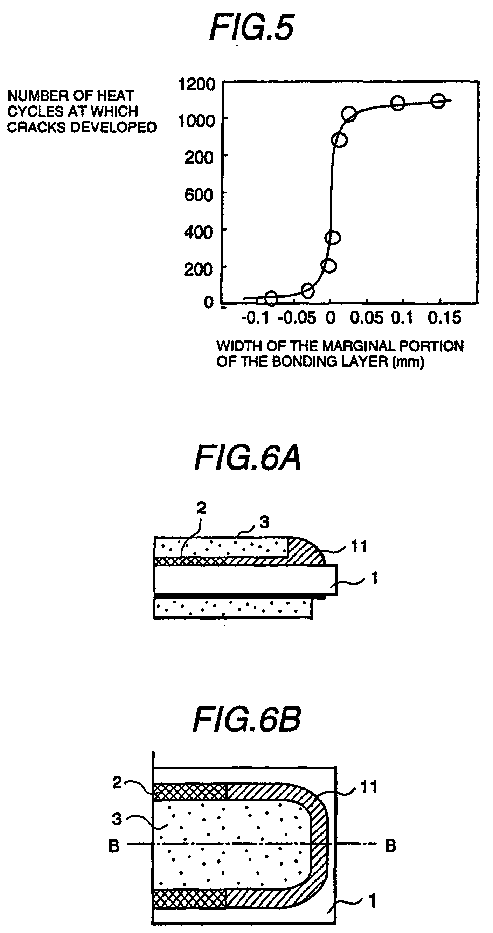

Referring to Fig. 4, showing a conventional module, a power semiconductor element 4 is bonded with solder 6 to a circuit board having an insulating substrate 1 provided with a wiring pattern of a conductive foil 3, and the circuit board is bonded to a metal base plate 8 of molybdenum or copper with solder 7. The insulating substrate 1 is a ceramic substrate of aluminum oxide, aluminum nitride or the like. A copper foil formed in a circuit pattern is bonded to the ceramic substrate by, for example, an active metal method disclosed in JP-A No. 60-177634 using a silver solder, or a method disclosed in JP-A No. 56-163093 which bonds a copper foil directly to an aluminum nitride substrate. The active metal method bonds a copper foil to an insulating substrate at a temperature lower than that at which the method bonds a copper foil directly to a substrate. Therefore, a residual stress induced within a structure formed by bonding a copper foil to an aluminum nitride insulating substrate by the active metal method due to the difference in coefficient of thermal expansion between the aluminum nitride insulating substrate and the copper foil is relatively small, and hence the structure is durable to thermal load that is exerted thereon by, for example, heat cycle.

Heat generated by the semiconductor element 4 is transferred through the circuit pattern of the conductive foil 3, the insulating substrate 1, the metal base plate 8 of molybdenum or copper and a grease layer 9 to a heat sink 10 which radiates heat. The temperatures of the insulating substrate 1 provided with the pattern of the conductive foil 3 , and the metal base plate 8, i.e., the components of the module, are elevated while the semiconductor element 4 is in operation. The temperatures of those components drop down after the operation of the semiconductor element 4 is stopped. Thus, the temperatures of the components of the module rise and drop repeatedly. Consequently, thermal stress is induced in the insulating substrate 1 due to difference in coefficient of thermal expansion between the insulating substrate 1 and the circuit pattern of the conductive foil 3.

Preferably the present invention provides a highly reliable circuit board and a highly reliable semiconductor device of a module structure including a power semiconductor element and an insulating substrate, capable of preventing the development of cracks in the insulating substrate.

According to the present invention a circuit board is provided according to Claim 1. Preferably, the circuit board is included in a semiconductor device according to Claim 5.

According to the present invention , a volume of the conductive foil on the marginal portion of the bonding layer is zero. Therfor,a thermal stress in a portion of the insulating substrate bonded to the marginal portion of the bonding layer is reduced.

Fig. 1 is a typical sectional view of a module.

Figs. 2(a) and 2(b) are a plan view and a sectional view, respectively, of an insulating substrate.

Fig. 3 is a plan view of a circuit pattern.

Fig. 4 is a typical sectional view of a conventional module.

Fig. 5 is a graph showing the dependence of the number of heat cycles at which cracks developed in the insulating substrate on the width of the marginal portion spreading outside beyond the edges of the circuit pattern of the conductive foil.

Figs. 6(a) and 6(b) are a sectional view and a plan view, respectively, of a portion of a circuit pattern according to the present invention.

Figs. 7(a) and 7(b) are a sectional view and a plan view, respectively, of a module according to the present invention.

Figs. 8(a) and 8(b) are a sectional view and a plan view, respectively, of an insulating substrate.

Figs. 9(a) and 9(a) are a sectional view and a plan view, respectively, of an insulating substrate.

Figs. 10(a) and 10(b) are a sectional view of edge of a circuit board.

### DESCRIPTION OF THE PREFERRED EMBODIMENTS

### First Example

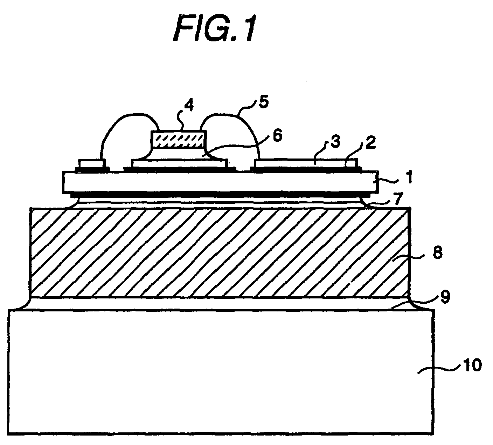

An example will be described in reference to Fig.1.

A conventional method fabricates an insulating substrate 1 provided with a circuit pattern 3 of a conductive foil by printing a bonding layer 2 in a pattern corresponding to the circuit pattern 3 on the insulating substrate 1, spreading a copper foil over the printed bonding layer 2, applying a pressure to the copper foil to bond the copper foil to the insulating substrate 1, etching the copper foil to form the circuit pattern 3 of the conductive foil. The bonding layer 2 is formed in a shape identical with the circuit pattern 3 of the conductive foil , i.e., the copper foil.

Usually, the conductive foil forming the circuit pattern 3 is a copper foil, and the insulating substrate 1 is made of a ceramic material. The coefficient of thermal expansion of copper is 17×10⁻⁶°C , and those of aluminum oxide and aluminum nitride are 6.5×10⁻⁶/°C and 4.5×10⁻⁶/°C , respectively. Therefore, a maximum stress is induced in a portion of the ceramic substrate corresponding to a marginal portion 14 of the circuit pattern 3 of the conductive foil due to difference in coefficient of thermal expansion between the conductive foil forming the circuit pattern 3 and the insulating substrate 1.

If the bonding layer 2 is formed in a pattern having a marginal portion 15 lying within the marginal portion 14 of the circuit pattern due to insufficient accuracy in the alignment of an etching mask for forming the circuit pattern and a printing mask for printing the bonding layer, an increased stress is concentrated on a portion of the ceramic substrate corresponding to the marginal portion 15 and thereby cracks are liable to be formed in the ceramic substrate. The stress induced in the ceramic substrate increases with the increase of the thickness of the conductive foil forming the circuit pattern 3. A method disclosed in JP-A No. 5-152461 forms the marginal portion 14 of the circuit pattern of the conductive foil in a reduced thickness by a mechanical means, such as a press, or a chemical means, such as etching. Therefore, there is the possibility that cracks are formed in the ceramic substrate by pressure applied to the ceramic substrate by a press or by an etching process. The example solves the problem by forming the bonding layer 2 in an area greater than that of the circuit pattern 3 of the conductive foil. Since the edges of the marginal portion 15 of the bonding layer 2 is not true with those of the marginal portion 14 of the circuit pattern 3 of the conductive foil, stress concentration on a particular portion of the ceramic substrate is alleviated regardless of the thickness of the conductive foil forming the circuit pattern 3. Experiments proved that a stress concentrated on the marginal portion 15 of the bonding layer 2 can be reduced by half when the circuit pattern 3 of the conductive foil lies within the surface of the pattern of the bonding layer 2, and the bonding layer 2, which is in direct contact with the ceramic substrate, is formed in a thickness smaller than that of the conductive foil forming the circuit pattern 3. Naturally, the edges of the circuit pattern 3 of the conductive foil may be tapered outward. The marginal portion of the circuit pattern 3 of the conductive foil may be subjected to etching. The circuit pattern 3 of the conductive foil may be formed by any method in any sectional shape. Thus, the reliability of the ceramic substrate can be secured even if the conductive foil forming the circuit pattern 3 has a big thickness to provide the circuit pattern 3 with a large current capacity. The example is particularly effective when applied to corner portions of the circuit pattern 3 of the conductive foil in which stress concentration is liable to occur.

### Second Example

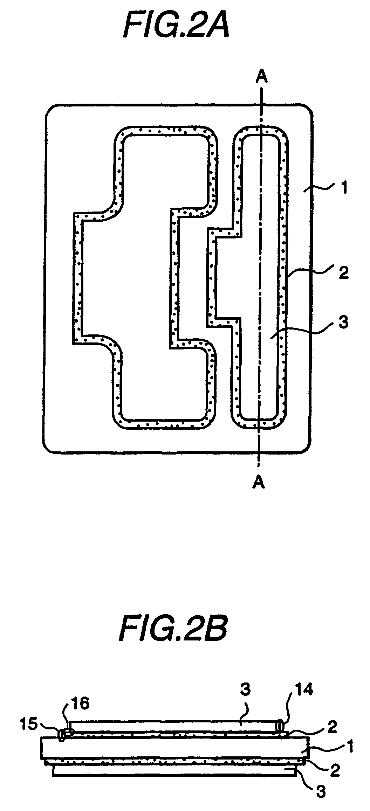

Fig. 2(a) is a plan view of an insulating substrate 1 provided with circuit pattern 3 of a conductive foil, and Figs. 2(b) is a sectional view taken on line A-A in Fig. 2(a). The insulating substrate 1 was an aluminum nitride substrate. The insulating substrate 1 may be a substrate of any suitable electrically insulating material, such as formed of a ceramic material other than aluminum nitride, such as aluminum oxide or silicon carbide, of a composite material formed by laminating a metal substrate and a ceramic substrate. A bonding layer 2 was formed by spreading a silver solder containing silver and copper as principal components. It is preferable that the silver solder contains a metal having a coefficient of thermal expansion between those of the material of the conductive foils forming the circuit patterns 3 and the material of the ceramic substrate to reduce adverse effects attributable to the difference in coefficient of thermal expansion between the circuit patterns 3 and the ceramic substrate. Preferably, titanium hydride is added to the silver solder to enhance the bonding strength between the silver solder and the aluminum nitride substrate. In this example, the circuit patterns 3 were formed by processing rolled copper foils. The insulating substrate 1 provided with the circuit patterns 3 of the conductive foils was fabricated by the following method. First, bonding layers 2 of the silver solder were formed in predetermined patterns over the opposite surfaces of the aluminum nitride substrate, respectively, by screen printing, and the bonding layers 2 were dried. Subsequently, copper foils were spread over and in close contact with the opposite surfaces of the aluminum nitride substrate on which the bonding layers 2 are formed, respectively, and pressure and heat were applied through spacers to the copper foils to obtain the insulating substrate with the copper foils bonded thereto. Then, the insulating substrate with the copper foils bonded thereto was subjected to an etching process to form the circuit patterns 3 of the conductive foils. In the edging process, resist patterns were formed so that the edges of the circuit patterns formed by etching the copper foils lie within the patterns of bonding layers of the silver solder. As shown in Fig. 2(a), the patterns of the bonding layers 2 thus formed have areas greater than those of the corresponding circuit patterns 3 of the conductive foils, respectively. The surfaces of the circuit patterns 3 of the conductive foils, i.e., the copper foils, formed on the insulating substrate 1 were coated with an antioxidation films by an electroless nickel-phosphorus plating process. Then, the insulating substrate 1 and electrode terminals, not shown, were bonded to a metal base plate 8 of molybdenum, and the assembly of the insulating substrate 1 and the metal base plate 8 were packaged in a case, not shown, to complete a module shown in Fig. 1. Table 1 shows the results of -40° C /125° C heat cycle tests of modules of different structures conducted to evaluate the heat cycle reliability of the modules.

**Table 1**

| Num.heart cycles | Test module 1 | Test module 2 | Test module 3 |
|---|---|---|---|
| 50 | × | ○ | ○ |
| 100 | × | ○ | ○ |
| 200 | × | × | ○ |
| 400 | × | × | ○ |
| 600 | × | × | ○ |
| 1000 | × | × | ○ |
| Note: Test module 1: Module provided with a bonding layer having a marginal portion lying inside the edges of a circuit pattern Test module 2: Module provided with a bonding layer having edges true with those of a circuit pattern Test module 3: Module provided with a bonding layer having a marginal portion spreading outside beyond the edges of the circuit pattern ○: No crack developed in the ceramic substrate. ×: Cracks developed in the ceramic substrate. | | | |

In Test module 3 provided with the silver solder layer having an area greater than that of the corresponding copper foil, no crack developed in the insulating substrate 1, the copper foil did not come off the insulating substrate 1 and the module functioned normally after 1000 heat cycles. In Test module 2 provided with the silver solder layer having an area and a shape the same as those of the copper foil, cracks developed in the insulating substrate 1 and the copper foil came off the insulating substrate after 200 heat cycles. In Test module 1 provided with the silver solder layer of an area and a shape smaller than those of the copper foil, cracks developed in the insulating substrate 1 and the copper foil came off the insulating substrate 1 after 50 heat cycles.

### Third Example

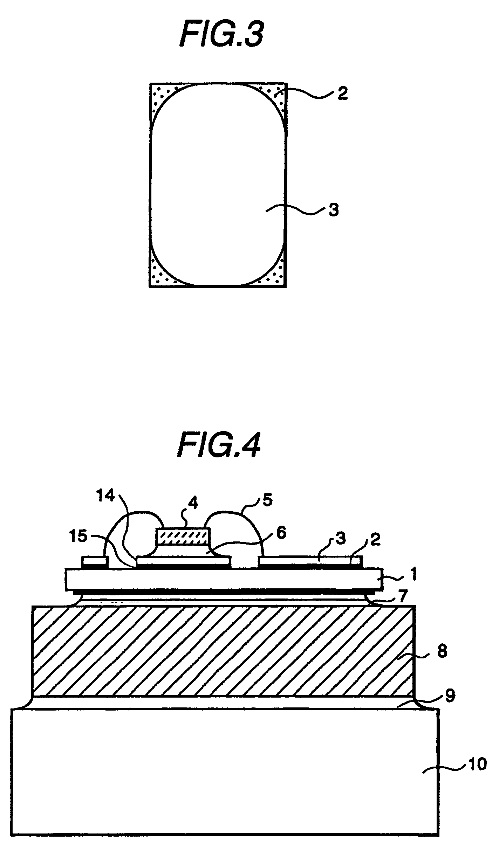

Fig. 3 is a plan view of a circuit pattern 3 of a conductive foil employed in the third example. It is preferable that the circuit pattern 3 of the conductive foil has a large area to carry a high current. Therefore, the straight edges of a circuit pattern 3 were formed so as to be true with the corresponding edges of a pattern of a bonding layer 2, and the corners of the circuit pattern 3 of the conductive foil were rounded in shapes of a radius of curvature greater than that of the corresponding corners of the pattern of the bonding layer 2. Thus, the corner portions of the pattern of the bonding layer 2 spread outside beyond the corresponding edges of the circuit pattern 3. The module in the third embodiment was subjected to a heat cycle test. No crack developed in the insulating substrate 1 after 1000 heat cycles.

As known from the results of the heat cycle test, the entire marginal portion of the bonding layer 2 need not necessarily spread outside beyond the edges of the circuit pattern 3 of the conductive foil; only portions of the pattern of the silver solder corresponding to the corner portions of the circuit pattern 3 of the conductive foil may spread outside beyond the corner portions of the circuit pattern 3.

### Fourth Example

Modules of different configurations differing from each other in the width of the marginal portion 16 spreading outside from the edges 14 of the circuit pattern of the conductive foil were fabricated by a method the same as that by which the module in the second example was fabricated. The circuit patterns were formed by processing a 0.3 mm thick copper foil bonded to an insulating substrate by a 0.03mm thick bonding layer. Fig. 5 is a graph showing the dependence of the number of heat cycles at which cracks developed in the insulating substrate on the width of the marginal portion 16 spreading outside beyond the edges 14 of the circuit pattern of the conductive foil. Practically, it is desirable that the module withstands at least 500 heat cycles without cracking. Cracks developed after 400 heat cycles in the module having a marginal portion 16 of 0.02 mm in width and after 800 heat cycles in the module having a marginal portion 16 of 0.03 mm in width. It is known from the results of the heat cycle tests that the cracking of the insulating substrate of the module can practically be prevented when the marginal portion 16 of the bonding layer has a width equal to or greater than the thickness of the bonding layer.

### Fifth Example

Modules of different configurations differing from each other in the thickness of the copper foil for forming the circuit pattern 31 were fabricated by a method the same as that by which the module in the second example was Fabricated. A 0.03 mm thick bonding layer 2 was used. The width of the marginal portion 16 of the bonding layer spreading outside from the edges 14 of the circuit pattern of the conductive foil was 0.1 mm for all the modules. The circuit patterns 3 were formed by processing 0.1 mm thick, 0.3 mm thick, 0.6 mm thick and 1.2 mm thick copper foils. Cracks developed in none of the modules and all the modules functioned normally after 1000 heat cycles.

### Sixth Example

Fig. 6(a) is a plan view of a portion of a circuit pattern 3 employed in the fourth example and Fig. 6(b) is a sectional view taken on line B-B in Fig. 6(a). A silver solder bonding layer 2 was employed. Corner portions of a pattern of the bonding layer 2 corresponding to corner portions of a circuit pattern 3 of a conductive foil were formed of patterns of a resin layer 11 of a silicone resin instead of the silver solder. The patterns of the resin layer 11 may be formed of any resin other than the silicone resin provided that the resin is capable of with standing heat of 150° C or above. The resin layer 11 spreads from under the peripheral portion of the circuit pattern to the outside of the same. Cracks did not develop the modules in the sixth example and the module functioned normally after 1000 heat cycles.

### Seventh Example

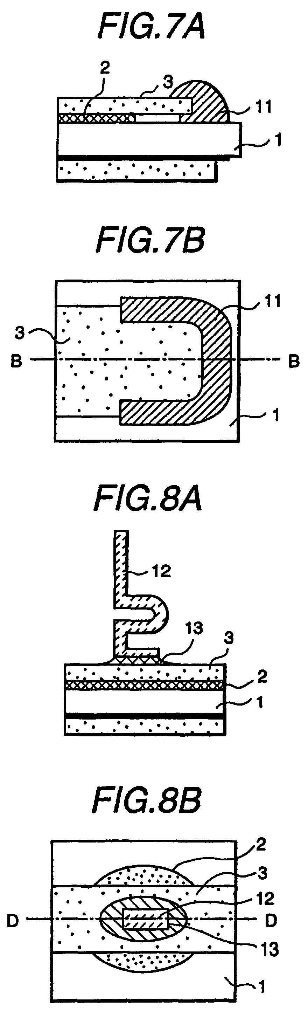

Figs. 7(a) and 7(b) are a fragmentary sectional view and a fragmentary plan view, respectively, of a module in the seventh example. It is preferable that the circuit pattern 3 of a conductive foil has a large area to carry a high current. Therefore, the straight edges of the circuit pattern 3 were formed so as to be true with the corresponding edges of a pattern of a bonding layer 2, and corner portions of the circuit pattern 3 were bonded to a substrate with a resin layer 11 instead of a silver solder. The resin layer 11 was formed so as to envelop the corner portions of the circuit pattern 3.

As shown in Figs. 7(a) and 7(b), a space 17 under the corner portion of the circuit pattern need not necessarily filled up entirely with the resin layer 11; the resin layer 11 may be formed along the edge of the circuit pattern so as to envelop the edge portion. Cracks did not develop the modules in the seventh embodiment and the module functioned normally after 1000 heat cycles.

### Eighth Example

Modules provided with bonding layers 2 of a silver solder having different thicknesses, respectively, were fabricated by a method the same as that by which the second example was fabricated. Circuit patterns 3 of the modules were formed by processing a 0.3 mm thick copper foil, and bonding layers were formed so that the width of a marginal portion of each bonding layer spreading outside beyond the edges 14 of each circuit pattern was 0.1 mm. The thicknesses of the bonding layers 2 of the silver solder of the modules were 0.01 mm, 0. 03 mm, 0.05 mm, 0.1 mm and 0.2 mm, respectively. Cracks developed in the ceramic substrate of the module provided with the 0.2 mm thick bonding layer of the silver solder before 1000 heat cycles, and no crack developed in the ceramic substrates of the modules provided with the bonding layers of a thickness not greater than 0.1 mm and those modules functioned normally after 1000 heat cycles.

### Ninth Example

Fig. 8(b) is a fragmentary plan view of an insulating substrate 1 provided with a circuit pattern 3 of a conductive foil in the nineth example, and Fig. 8(a) is a sectional view taken on line D-D in Fig. 8(b). An electrode terminal 12 formed by bending a steel sheet is bonded to the circuit pattern 3 by a terminal bonding layer 13 of a solder. As shown in Fig. 8(b), portions of a bonding layer 2 spread outside beyond the edges of the circuit pattern 3. When the module experiences heat cycles, the electrode terminal 12 is caused to expand by heat, the ceramic substrate is strained through the circuit pattern 3 underlying the electrode terminal by the electrode terminal and a stress is induced in the ceramic substrate. If a portion of the circuit pattern around the electrode terminal 12 has a small area, a high stress is induced in a portion of the ceramic substrate corresponding to the edges of the circuit pattern. The stress induced in the ceramic substrate can be reduced by forming the bonding layer 2 in a width greater than that of the circuit pattern 3 as shown in Fig. 8(b). In the module in the eighth example, a maximum width of portions of the bonding layer 2 lying outside the circuit pattern 3 as shown in Fig. 8(b) was 0.2 mm, and the electrode terminal 12 was bonded to the circuit pattern 12 formed on the substrate. No crack developed in the module and the module functioned normally after 1000 heat cycles.

A substrate in a comparative example provided with a circuit pattern 3 and a bonding layer not spreading outside beyond the edges of the circuit pattern 3 was fabricated, and a module was fabricated by bonding an electrode terminal 12 to the substrate. The module in the comparative example was unable to function normally after 1000 heat cycles. The module was disassembled and examined after 1000 heat cycles. Cracks were found in a portion of the ceramic substrate around the electrode terminal 12.

### Tenth Example

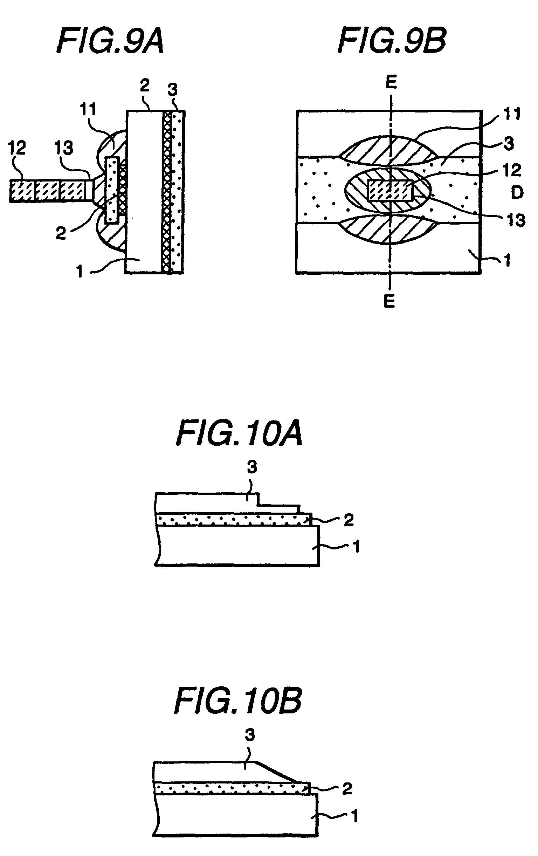

Fig. 9(b) is a fragmentary plan view of an insulating substrate 1 provided with a circuit pattern 3 of a conductive foil in the tenth example and Fig. 9(a) is a sectional view taken on line E-E in Fig. 9(b). An electrode terminal 12 is bonded to the circuit pattern 3 by a bonding layer 13. In the tenth example, resin layers 11 were formed around the electrode terminal 12 to form circuit patterns, not shown, adjacent to the circuit pattern 3 can be disposed as near as possible to the circuit pattern 3 with the least necessary isolation space therebetween. The module in the ninth embodiment functioned normally after 1000 heat cycles.

### Eleventh example

Fig. 10 shows coss-sections of edges of circuit boards.

In fig.10(a), a marginal portion of a copper foil 3 has a shape like steps. A thickness of the marginal portion of the copper foil 3 is smaller than a portion of the copper foil 3 inside the marginal portion.
A marginal portion of a bonding layer 2 spreads outside an edge of the copper foil 3.

In Fig . 10(b), a maginal portion of the copper foil 3 has a taper shape. A thickness of the marginal portion of the copper foil 3 gradually becomes smaller than a portion of the copper foil 3 inside the maginal portion. A marginal portion of a bonding layer 2 spreads outside an edge of the copper foil 3.

According to the example in fig .10(a) and 10(b), a thermal stress in a portion of the ceramic substrate 1 bonded to the marginal portion of the bonding layer 2 is reduced. Additionally, a thermal stess in a portion of the ceramic substrate 1 under the marginal portion of the copper foil 3.

An edge of the copper foil 3 can be trued up to an edge of the bonding layer 2.

According to the present invention, the degree of stress concentration in a portion of the insulating substrate caused by the circuit pattern can be reduced and thereby the reliability of the semiconductor device against repetitive thermal loading can be improved.

## Claims

1. A circuit board comprising: an insulating substrate (1); and a conductive foil bonded to the insulating substrate with a bonding layer (2); wherein the bonding layer (2) has an area greater than that of the conductive foil, wherein a marginal portion (15) of the bonding layer spreading outside beyond the edges of the conductive foil has a width greater than the thickness of the bonding layer (2) underneath the conductive foil.

2. The circuit board according to Claim 1, wherein the thickness of the marginal portion (15) of the bonding layer spreading outside beyond the edges of the conductive foil is 0.1 mm or below.

3. The circuit board according to Claim 1, wherein the conductive foil is bonded to the insulating substrate (1) with a plurality of kinds of bonding layers.

4. The circuit board according to Claim 3, wherein a plurality of kinds of bonding layers the same as those bonding the conductive foil to the insulating substrate (1) are formed on the conductive foil.

5. A semiconductor device comprising: a circuit board according to any one of the above claims, a metal base plate wherein the insulating substrate is placed on the metal base plate; and a semiconductor element mounted on the conductive foil.

## Patentansprüche

1. Platine mit einem isolierenden Substrat (1) und einer durch eine Bindeschicht (2) mit dem isolierenden Substrat verbundenen leitenden Folie, wobei die Bindeschicht (2) eine größere Fläche hat als die leitende Folie und ein sich nach außen über die Kanten der leitenden Folie hinweg erstreckender Randbereich (15) der Bindeschicht eine Breite hat, die größer ist als die Dicke der Bindeschicht unterhalb der leitenden Folie.

2. Platine nach Anspruch 1, wobei die Dicke des sich nach außen über die Kanten der leitenden Folie hinweg erstreckenden Randbereichs (15) der Bindeschicht 0,1 mm oder weniger beträgt.

3. Platine nach Anspruch 1, wobei die leitende Folie mit dem isolierenden Substrat (1) durch mehrere Arten von Bindeschichten verbunden ist.

4. Platine nach Anspruch 3, wobei auf der leitenden Folie mehrere Arten von Bindeschichten ausgebildet sind, die mit denen übereinstimmen, die die leitende Folie mit dem isolierenden Substrat (1) verbinden.

5. Halbleiterbauelement mit einer Platine nach einem der vorhergehenden Ansprüche, einer metallischen Basisplatte, auf der das isolierende Substrat angeordnet ist, und einem auf der leitenden Folie aufgebrachtes Halbleiterelement.

## Revendications

1. Plaquette de circuit imprimé comprenant : un substrat isolant (1) ; et une feuille conductrice liée au substrat isolant avec une couche de liaison (2) ; où la couche de liaison (2) a une surface plus grande que celle de la feuille conductrice, où une portion marginale (15) de la couche de liaison s'étalant à l'extérieur au-delà des bords de la feuille conductrice a une largeur plus grande que l'épaisseur de la couche de liaison (2) en dessous de la feuille conductrice.

2. Plaquette de circuit imprimé selon la revendication 1, où l'épaisseur de la portion marginale (15) de la couche de liaison s'étalant vers l'extérieur au-delà des bords de la feuille conductrice est de 0,1 mm ou inférieure.

3. Plaquette de circuit imprimé selon la revendication 1, où la feuille conductrice est liée au substrat isolant (1) avec une pluralité de types de couches de liaison.

4. Plaquette de circuit imprimé selon la revendication 3, où une pluralité de types de couches de liaison, les mêmes que celles liant la feuille conductrice au substrat isolant (1), sont formées sur la feuille conductrice.

5. Dispositif semi-conducteur comprenant : une plaquette de circuit imprimé selon l'une des revendications ci-dessus, une plaque de base métallique dans laquelle le substrat isolant est placé sur la plaque de base métallique ; et un élément semi-conducteur monté sur la feuille conductrice.
